(19) Europäisches Patentamt / European Patent Office / Office européen des brevets

(11) **EP 2 768 030 A2**

(12) **EUROPEAN PATENT APPLICATION**

(43) Date of publication:
20.08.2014 Bulletin 2014/34

(51) Int Cl.:
*H01L 31/0749* (2012.01)

(21) Application number: 13190373.4

(22) Date of filing: 25.10.2013

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **19.02.2013 US 201361766585 P**

(71) Applicant: **Samsung SDI Co., Ltd.**
**Yongin-si, Gyeonggi-do (KR)**

(72) Inventors:
• **Kim, Jeong-Hoon**
**Gyeonggi-do (KR)**
• **Ahn, Sang-Hyuck**
**Gyeonggi-do (KR)**

• **Kim, Hyun-Chul**
**Suwon-si, Gyeonggi-do**
**443-803 (KR)**
• **Cha, Si-Young**
**Suwon-si, Gyeonggi-do**
**443-803 (KR)**
• **Baik, Nam-Seok**
**Gangam-gu**
**Seoul 135-971 (KR)**

(74) Representative: **Mounteney, Simon James**
**Marks & Clerk LLP**
**90 Long Acre**
**London**
**WC2E 9RA (GB)**

(54) **Solar cell and method of manufacturing the same**

(57) Provided is a solar cell that includes a light absorption layer including an p-type compound semiconductor, a buffer layer that comprises a second buffer layer disposed on the light absorption layer and a first buffer layer disposed on the second buffer layer, and a ZnS content of the first buffer layer is greater than a ZnS content of the second buffer layer.

【 FIG. 3】

**Description**

[Technical Field]

The present invention relates to a solar cell and a method of manufacturing the same.

[Prior Art]

Solar cells are a representative alternative energy that directly converts solar energy into electric energy, produces less pollutants, and is semi-permanent.

Silicon solar cells may include bulky mono-crystalline silicon or polycrystalline silicon, or amorphous silicon. Silicon solar cells may have high efficiency, but their manufacturing costs are high. Organic solar cell may have low manufacturing costs, but their efficiency and stability are low. Compound semiconductor solar cells have lower manufacturing costs and higher efficiency and stability than silicon solar cells.

A compound semiconductor solar cell may include a light absorption layer formed of a p-type compound semiconductor and an n-type buffer layer disposed on the p-type compound semiconductor. The light absorption layer may be a CIGS thin film, such as $Cu(In, Ga)Se_2$, and the buffer layer may be formed of, for example, CdS, ZnO, or ZnS.

However, use of such buffer layers may provide solar cells with insufficient efficiency.

Accordingly, a buffer layer that further improves efficiency of a solar cell is required.

[Disclosure of the Invention]

An aspect of the present invention provides a solar cell including a buffer layer having a novel structure. The solar cell of the present invention is defined in claims 1 to 14.

Another aspect of the present invention provides a method of manufacturing the solar cell. The process of the present invention is defined in claim 15.

According to an embodiment of the present invention, provided is a solar cell including:

a light absorption layer including an p-type compound semiconductor;

a buffer layer that is disposed on the light absorption layer and contains ZnS; and

a window layer that is disposed on the buffer layer and includes an n-type metal oxide semiconductor,

wherein the buffer layer comprises a second buffer layer disposed on the light absorption layer and a first buffer layer disposed on the second buffer layer, and

a ZnS content of the first buffer layer is greater than a ZnS content of the second buffer layer.

According to another embodiment of the present invention, provided is a method of manufacturing a solar cell, the method including:

preparing an aqueous solution including zinc sulfate ($ZnSO_4$), thiourea ($SC(NH_2)_2$), and ammonium hydroxide ($NH_4OH$); and

immersing a light absorption layer including the p-type compound semiconductor in the aqueous solution for 7 minutes or more.

[Effect of the Invention]

Due to the inclusion of a buffer layer having a novel structure, open voltage and conversion efficiency of a solar cell are improved.

[Brief Description of the Drawings]

FIG. 1 is a schematic diagram of a thin film solar cell according to an embodiment of the present invention.

FIG. 2 shows an Auger electron spectroscopy (AES) spectrum of a solar cell prepared according to Preparation Examples 1 to 2 and Comparative Preparation Example 1.

FIG. 3 shows a graph showing surface analysis results and conversion efficiency of solar cells prepared according to Examples 1 to 5, Reference Example 1 and Comparative Example 1.

Explanation of Reference numerals designating the Major Elements of the Drawings

| | | | | |
|---|---|---|---|---|
| 1: | glass substrate | 2: | metal opposite electrode layer |
| 3: | light absorption layer | 4: | buffer layer |
| 4a: | second buffer layer | 4b: | first buffer layer |
| 5: | window layer (transparent electrode) | | |

[Description of Embodiment]

Hereinafter, solar cells and methods of manufacturing the same, according to embodiments of the present invention, are described in further detail.

A solar cell according to an embodiment of the present invention includes a light absorption layer including an p-type compound semiconductor, a buffer layer that is disposed on the light absorption layer and contains ZnS, and a window layer that is disposed on the buffer layer and includes an n-type metal oxide semiconductor, wherein the buffer layer includes a second buffer layer disposed on the light absorption layer and a first buffer layer disposed on the second buffer layer, and a ZnS content of the first buffer layer is greater than a ZnS content of the second buffer layer.

Since the first buffer layer has greater ZnS content than the second buffer layer, open voltage and conversion efficiency of the solar cell may be improved. For example, since the first buffer layer has greater ZnS content than the second buffer layer, a band gap is high. Accordingly, efficiency of the solar cell may be improved by controlling a thickness of the first buffer layer in order to align band gaps of the buffer layer and the light absorption layer.

The ZnS content of the buffer layer of the solar cell may have such a concentration gradient in which the ZnS content (e.g., concentration) decreases in a direction (e.g., along a direction) from the first buffer layer to the second buffer layer. For example, the ZnS content of the buffer layer may continuously decrease in the direction from the first buffer layer to the second buffer layer. The term "concentration gradient" has the meaning standard in the art, i.e. a gradient in concentration of ZnS as a function of distance through the buffer layer. The concentration is higher at the first buffer layer and decreases towards the second buffer layer. By continuously it is preferably meant that there is a continuous decrease at the level of accuracy this parameter is measured by, for example by Auger electron spectroscopy (AES).

In an embodiment of the invention, a ratio of ZnS content to Zn(S,O,OH) content, ZnS/Zn(S,O,OH), which is preferably calculated from the AES spectrum of the first buffer layer, may be in a range of about 0.25 to about 0.63. In an embodiment of the present invention, this value is an average across the first buffer layer. For example, a ratio of ZnS content to Zn(S,O,OH) content, which is calculated from the AES spectrum of the first buffer layer, may be in a range of about 0.25 to about 0.61, optionally from about 0.27 to about 0.60, and optionally from about 0.29 to about 0.50, for example about 0.30 to about 0.60. When the ratio of ZnS/Zn(S,O,OH) in the first buffer layer is greater than or equal to 0.25 or less than or equal to 0.36, conversion efficiency of the solar cell is particularly increased.

In an embodiment of the invention, a ratio of ZnS content to Zn(S,O,OH) content, which is calculated from the Auger electron spectroscopy (AES) spectrum of the second buffer layer, may be less than 0.25, optionally the ZnS/Zn(S,O,OH) of the second buffer layer is from about 0.10 to about 0.24, optionally from about 0.15 to about 0.23, and optionally from about 0.19 to about 0.23. When the ratio of ZnS/Zn(S,O,OH) in the second buffer layer is 0.25 or more, conversion efficiency of the solar cell may decrease. In an embodiment of the present invention, this value is an average across the second buffer layer. Accordingly, these values are averages, the fact that the averages for the first and second buffer layers are not continuous values; this does not mean that the actual concentration gradient is not continuous. In an embodiment of the present invention, for example, a thickness ratio of the first buffer layer to the second buffer layer in the solar cell may be in a range of 3:1 to 1:3. For example, a thickness ratio of the first buffer layer to the second buffer layer in the solar cell may be in a range of 1.1:0.9 to 0.9:1.1. For example, the first buffer layer to the second buffer layer in the solar cell may have a substantially identical thickness. When the first buffer layer and the second buffer layer have such thickness ratios, conversion efficiency of the solar cell is optimised.

In an embodiment of the present invention, the first buffer layer and the second buffer layer of the solar cell may be monolithic. That is, the first buffer layer and the second buffer layer may be continuously formed without a distinguishable interface therebetween (e.g., as a single buffer layer). For example, regarding a single buffer layer prepared by using one preparation method, based on a thickness direction of the buffer layer, an upper portion, preferably half, thereof may be referred to as a first buffer layer and a lower portion, preferably half, thereof may be referred to as a second buffer layer. In this embodiment, it is preferably the upper portion that has the average ZnS ratios described above for the first layer and the lower portion that has the average ZnS ratios described above for the second layer. In addition, in an embodiment of the present invention throughout the first buffer layer and the second buffer layer, the ZnS content may continuously decrease in the direction from the first buffer layer to the second buffer layer.

The buffer layer of the solar cell may have a thickness of about 1 nm to about 2 $\mu$m For example, a thickness of the buffer layer (e.g., a combined thickness of the first buffer layer and the second buffer layer) may be in a range of about 1 nm to about 200 nm, but is not limited thereto. In an embodiment of the present invention, the total buffer layer is between 1.5 nm to about 10 nm and optionally 1.7 nm to about 8 nm.

The thickness of the buffer layer may vary within the scope of the present invention.

The first buffer layer of the buffer layer may be in a range of about 0.5 nm to about 1 $\mu$m For example, a thickness of the first buffer layer may be in a range of about 0.5 nm to about 100 nm. In addition, a thickness of the second buffer layer of the buffer layer may be in a range of about 0.5 nm to about 1 $\mu$m For example, a thickness of the second buffer layer may be about 0.5 nm to about 100 nm.

In an embodiment of the present invention, the first and second buffer layers may independently be between 0.75 nm to about 5 nm in thickness and optionally 0.85 nm to about 4 nm.

In an embodiment of the present invention, the light absorption layer of the solar cell may have a Group I-III-VI2 chalcopyrite structure with p-type conductivity. For example, the light absorption layer may be a thin film including a multinary compound semiconductor, such as $CuInSe_2$, $Cu(In,Ga)Se_2$, or $Cu(In,Ga)(S,Se)_2$.

For example, the light absorption layer of the solar cell may be a thin film having a compound semiconductor having Composition Formula 1 below.

$$<\text{Composition Formula 1}> \qquad CuIn_{1-x}Ga_x(S_ySe_{1-y})_2$$

wherein $0 \leq x < 1$, $0 < y < 1$.

In addition, the light absorption layer may be a selenide-based CIS-based light absorption layer, a sulfide-based CIS-based light absorption layer, or a selenide·sulfide-based CIS-based light absorption layer. The selenide-based CIS-based light absorption layer may be $CuInSe_2$, $Cu(In,Ga)Se_2$, or $CuGaSe_2$, the sulfide-based CIS-based light absorption layer may be $CuInS_2$, $Cu(InGa)S_2$, or $CuGaS_2$, and the selenide·sulfide-based CIS-based light absorption layer may be $CuIn(S,Se)_2$, $Cu(In,Ga)(SSe)_2$, or $CuGa(S,Se)_2$. In another embodiment of the present invention, the light absorption layer may further include a surface layer. Examples of such a light absorption layer are $CuInSe_2$ with $CuIn(S,Se)_2$ as a surface layer; $Cu(In,Ga)Se_2$ with $CuIn(S,Se)_2$ as a surface layer; $Cu(InGa)(SSe)_2$ with $CuIn(S,Se)_2$ as a surface layer; $CuGaSe_2$ with $CuIn(S,Se)_2$ as a surface layer; $Cu(In,Ga)Se_2$ with $Cu(In,Ga)(S,Se)_2$ as a surface layer; $CuGaSe_2$ with $Cu(In,Ga)(S,Se)_2$ as a surface layer; $Cu(In,Ga)Se_2$ with $CuGa(S,Se)_2$ as a surface layer; and $CuGaSe_2$ with $CuGa(S,Se)_2$ as a surface layer.

The light absorption layer may be formed by, for example selenization/sulfuration or co-deposition of multiple materials. When the light absorption layer is formed by selenization/sulfuration, either a stack structure including copper (Cu), indium (In), or gallium (Ga), or a mixed crystal of metal precursor film (Cu/In, Cu/Ga, Cu-Ga alloy/In, Cu-Ga-In alloy, etc.) is formed on a surface of a metal opposite electrode layer by, for example, sputtering or deposition, and then a heat treatment is performed thereon under a selene and/or sulfur-containing atmosphere to form the light absorption layer. When the light absorption layer is formed by co-deposition of multiple materials, a raw material including copper (Cu), indium (In), gallium (Ga), and selenium (Se) are simultaneously deposited at an appropriate combination on a glass substrate with an opposite electrode layer thereon which is heated at the temperature of 500°C or more to form the light absorption layer.

In an embodiment of the present invention, a surface of the light absorption layer of the solar cell (e.g., preferably a portion of the light absorption layer up to 10 nm in depth from the surface of the light absorption layer) may have a sulfur(S) concentration of 0.5 atom% or more. For example, a surface of the light absorption layer may have a sulfur(S) concentration of 3 atom% or more, optionally between 5 atom % and 30 atom %, or between 10 atom % and 25 atom %. When the surface of the light absorption layer has the sulfur concentration of 0.5 atom% or more, an optical band gap at an optical incident surface may increase and thus, incident light may be effectively absorbed. In addition, interfacial characteristics of the light absorption layer and the buffer layer may improve.

In an embodiment of the present invention, a thickness of the light absorption layer may be in a range of about 1 $\mu$m to about 3 $\mu$m For example, the light absorption layer may have a thickness of about 1.5 $\mu$m to about 2 $\mu$m, but the thickness thereof is not limited thereto, and may vary within the scope of the present invention.

In an embodiment of the present invention, the window layer of the solar cell is a film that has n-type conductivity, a wide band gap, transparency, and low resistance. An example thereof is a zinc oxide-based thin film thin film or an indium tin oxide (ITO) thin film. An n-type window layer, in the case of a zinc-oxide thin film, may include, as a dopant, a Group III element, for example, aluminium (Al), galium (Ga), boron (B), or a combination thereof. The window layer may be a transparent conductive layer having a thickness of about 5 nm to about 2.5 $\mu$m For example, a thickness of the window layer may be in a range of about 50 nm to about 2 $\mu$m, but is not limited thereto, and the thickness of the window layer may vary within the scope of the present invention.

In an embodiment of the present invention, the buffer layer of the solar cell may further include a third buffer layer disposed on the first buffer layer. The third buffer layer may be formed of an intrinsic ZnO. A thickness of the third buffer layer may be in a range of about 10 nm to about 2 $\mu$m For example, a thickness of the third buffer layer may be in a range of about 15 nm to about 200 nm, but is not limited thereto, and the thickness of the third buffer layer may vary within the scope of the present invention.

In an embodiment of the present invention, the light absorption layer of the solar cell may be formed on a supporting substrate. The supporting substrate may be a glass substrate, a plastic substrate, a metal substrate. The supporting substrate may be rigid or flexible. For example, the supporting substrate may be a soda lime glass substrate. A thickness of the supporting substrate may be in a range of about 0.1 $\mu$m to about 100 $\mu$m, but is not limited thereto, and the thickness of the supporting substrate may vary within the scope of the present invention.

In an embodiment of the present invention, a bottom electrode or an opposite electrode is formed between the supporting substrate and the light absorption layer in the solar cell. The opposite electrode may be formed of Mo, Cr, W, or a combination thereof. For example, the opposite electrode may be formed of Mo. A thickness of the opposite electrode may be in a range of about 200 nm to about 1000 nm, but is not limited thereto, and the thickness of the opposite electrode may vary within the scope of the present invention.

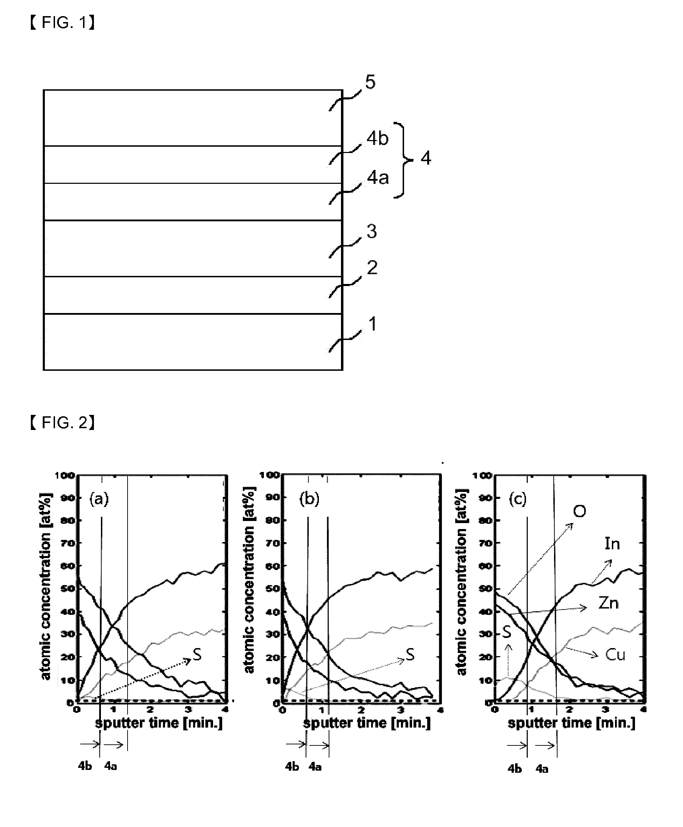

For example, the solar cell may have a structure illustrated in FIG. 1. As illustrated in FIG. 1, a metal opposite electrode layer 2 may be disposed on a glass substrate 1, a light absorption layer 3 may be disposed on the metal opposite electrode layer 2, a buffer layer 4 may be disposed on the light absorption layer 3, and a window layer 5 may be disposed on the buffer layer 4. The window layer 5 is also a transparent conductive electrode layer. The buffer layer 4 may include a second buffer layer 4a disposed on the light absorption layer and a first buffer layer 4b disposed on the second buffer layer 4a. Although not illustrated in FIG. 1, a third buffer layer may be additionally disposed between the first buffer layer 4b and the window layer 5.

In an embodiment of the present invention, the buffer layer of the solar cell may be formed by growing a compound semiconductor film from an aqueous solution to form a hetero junction with the light absorption layer by, for example, chemical bath deposition (CBD).

In an embodiment of the present invention, the solar cell is produced by a process comprising the steps of: preparing an aqueous solution including zinc sulfate ($ZnSO_4$), thiourea ($SC(NH_2)_2$) and ammonium hydroxide ($NH_4OH$); and immersing a light absorption layer including a p-type compound semiconductor in the aqueous solution for about 7 minutes to about 30 minutes.

In an embodiment of the present invention, a method of manufacturing a solar cell according to another embodiment of the present invention includes: preparing an aqueous solution including zinc sulfide ($ZnSO_4$), thiourea ($SC(NH_2)_2$) and ammonium hydroxide ($NH_4OH$); and immersing a light absorption layer including a p-type compound semiconductor in the aqueous solution for 15 minutes or more. A solar cell manufactured by using the method according to the present embodiment may have high open voltage and conversion efficiency.

Due to the 7 or minutes of immersion, the first buffer layer may have a higher ZnS content than the second buffer layer. When the immersion time is less than 7 minutes in the method, a difference in the ZnS contents of the first buffer layer and the second buffer layer is negligible and thus, conversion efficiency may decrease.

For example, the light absorption layer may be immersed in the aqueous solution for about 7 minutes to about 30 minutes. For example, the light absorption layer may be immersed in the aqueous solution for about 10 minutes to about 30 minutes, about 15 minutes to about 30 minutes, about 7 minutes to about 20 minutes, about 7 minutes to about 15 minutes or about 10 minutes to about 20 minutes. When the immersion time is too long, the first buffer layer may be too thick so that a series resistance of the buffer layer increases and thus conversion efficiency of the solar cell may decrease.

In an embodiment of the present invention, a temperature of the aqueous solution may be in a range of about 55°C to about 70°C, while the light absorption layer is being immersed in the aqueous solution. In an embodiment of the present invention, optionally the temperature is in a range of 55°C to less than 70°C, optionally the temperature is a range of 60°C to 68°C, optionally 62 °C to 66°C, while the light absorption layer is being immersed in the aqueous solution. Within the temperature range described above, a solar cell providing high open voltage and conversion efficiency may be obtained. When the temperature of the aqueous solution is lower than 55°C, a reaction rate may decrease, and when the temperature of the aqueous solution is higher than 70 °C, the Zn(OH) content (e.g., concentration) of the aqueous solution may be too high.

In a preferred embodiment of the present invention the immersion is for about 7 minutes to about 30 minutes at temperature is in a range of 55°C to less than 70°C, optionally the immersion is for about 7 minutes to about 20 minutes, about 7 minutes to about 15 minutes or about 10 minutes to about 20 minutes at temperature that is in a range of 60°C to less than 68°C.

In an embodiment of the present invention, in the method, the concentration of the zinc component, preferably zinc sulfide, may be in a range of about 0.01 M to about 0.1M, optionally about 0.02M to about 0.05M, and optionally about 0.03M to about 0.04M. Within the zinc sulfide concentration range, a buffer layer providing high open voltage and conversion efficiency may be manufactured. When the zinc sulfide concentration is less than 0.01 M, a reaction rate may decrease, and when the zinc sulfide concentration is higher than 0.1 M, an increase in a reaction rate may be negligible although manufacturing costs may increase.

In an embodiment of the present invention, in the method, a thiourea or alternative compound thereto concentration may be in a range of about 0.20M to about 1.3M, optionally about 0.30M to about 1.0M, and optionally about 0.40M to about 0.70M. Within the thiourea concentration range described above, a solar cell providing high open voltage and conversion efficiency may be manufactured. When the thiourea concentration is less than 0.2M, a reaction rate may decrease, and when the thiourea concentration is higher than 1.3M, an increase in a reaction rate may be negligible although manufacturing costs may increase.

In an embodiment of the present invention, in the method, an ammonium hydroxide or alternative compound thereto concentration may be in a range of about 1M to about 5M optionally about 1.5M to about 4M, and optionally about 2M to about 3M. Within the ammonium hydroxide concentration, a solar cell providing high open voltage and conversion efficiency may be manufactured. When the ammonium hydroxide concentration is less than 1M, efficiency characteristics may decrease, and when the ammonium hydroxide concentration is higher than 5M, efficiency characteristics may decrease.

In a preferred embodiment of the invention, the above three components are present in the concentrations about 0.02M to about 0.05M, about 0.30M to about 1.0M and about 1.5M to about 4M, respectively.

In a preferred embodiment of the invention, a mole ratio of zinc sulfide: thiourea :ammonium hydroxide may be 1:7~30:30~120 in the aqueous solution.

In a preferred embodiment of the invention, in the method, a pH of the aqueous solution may be in a range of about 10 to about 13. For example, a pH of the aqueous solution in the method may be in a range of about 10 to about 12. Within the pH range of the aqueous solution, a solar cell providing high open voltage and conversion efficiency may be manufactured. When a pH of the aqueous solution is less than 10, a reaction rate may decrease, and even when a pH of the aqueous solution is higher than 13, a reaction rate may decrease.

In an embodiment of the invention, the method may further include, after the forming of the buffer layer, annealing at the temperature of about 100 to about 300°C in an atmospheric condition. Due to the annealing, a dense and homogeneous buffer layer may be formed. In an embodiment of the invention, the annealing is carried out for a period of 30 minutes to 2 hours, optionally 45 minutes to 1.5 hours.

In an embodiment of the invention, the light absorption layer may be formed on an insulating substrate (e.g., an electrically insulating substrate) coated with a metal opposite electrode. The metal opposite electrode may be formed by, for example, sputtering.

In an embodiment of the invention,, the third buffer layer may be additionally formed on the buffer layer including the first buffer layer and the second buffer layer. The third buffer layer may be formed by, for example, sputtering. The third buffer layer may be formed of intrinsic ZnO.

In an embodiment of the invention, the window layer may be formed on the third buffer layer. The window layer may be a transparent conductive layer. For example, the window layer may be a transparent conductive electrode layer. The window layer may be formed by, for example, sputtering, and may be formed of Al-doped ZnO. In addition, a grid electrode may be additionally formed on the window layer by, for example, sputtering. The grid electrode may be formed of Al or the like. A thickness of the grid electrode is not particularly limited, and may be in a range of about 0.1 $\mu$m to about 3 $\mu$m

Embodiments of the present invention are described in detail with reference to examples and comparative examples. However, the examples are presented herein for illustrative purpose only, and do not limit the scope of the present invention.

(Formation of buffer layer)

Preparation Example 1:

An Mo bottom electrode having a thickness of 0.8 $\mu$m was formed on a soda lime glass (SLG) substrate with a size of 30 mmx30 mm by sputtering. A Cu(In$_{0.7}$Ga$_{0.3}$)Se$_2$ light absorption layer was formed on the Mo bottom electrode by multinary simultaneous deposition.

0.038M zinc sulfide, 0.55M thiourea, and 2.5M ammonium hydroxide were added to distilled water to prepare an aqueous solution having a pH of 10.5 and a temperature of 65°C.

The substrate with the light absorption layer was vertically immersed in the aqueous solution for 15 minutes, and then, dried at room temperature to form a buffer layer. A thickness of the buffer layer was 3 nm. The buffer layer was annealed at the temperature of 200°C for 1 hour.

Preparation Example 2:

A solar cell was manufactured in the same manner as in Preparation Example 1, except that the immersion time was 30 minutes.

Alternative Preparation Example 2:

A solar cell was manufactured in the same manner as in Preparation Example 1, except that the immersion time was 10 minutes.

(Manufacturing of solar cell)

Example 1

An Mo bottom electrode having a thickness of 0.8 $\mu$m was formed on a soda lime glass (SLG) substrate with a size of 30 mmx30 mm by sputtering. A $Cu(In_{0.7}Ga_{0.3})(S,Se)_2$ light absorption layer was formed on the Mo bottom electrode by co-deposition of multiple materials. A sulfur (S) content of the surface of the light absorption layer was about 20 atom%.
0.038M zinc sulfide, 0.55M thiourea, and 2.5M ammonium hydroxide were added to distilled water to prepare an aqueous solution having a pH of 10.5 and a temperature of 65°C.
The substrate with the light absorption layer was vertically immersed in the aqueous solution for 30 minutes, and then taken out to be dried at room temperature to form a buffer layer. A thickness of the buffer layer was 5 nm. The buffer layer was annealed at an atmospheric condition at the temperature of 200°C for 1 hour.
Subsequently, an i-ZnO third buffer layer having a thickness of 50 nm and an Al-doped ZnO(AZO) window layer having a thickness of 300 nm were sequentially formed on the buffer layer by sputtering, thereby completing the manufacturing of a solar cell.
In the solar cell, a upper half of the buffer layer was a first buffer layer and a lower half of the buffer layer was a second buffer layer. Accordingly, a thickness ratio of the first buffer layer to the second buffer layer is 1:1.

Example 2

A solar cell was manufactured in the same manner as in Example 1, except that the immersion time was 15 minutes. A thickness of the buffer layer was 3 nm.

Example 3

A solar cell was manufactured in the same manner as in Example 1, except that the immersion time was 12 minutes. A thickness of the buffer layer was 2.5 nm.

Example 4

A solar cell was manufactured in the same manner as in Example 1, except that the immersion time was 10 minutes. A thickness of the buffer layer was 2.3 nm.

Example 5

A solar cell was manufactured in the same manner as in Example 1, except that the immersion time was 7 minutes. A thickness of the buffer layer was 2 nm.

Reference Example 1

A solar cell was manufactured in the same manner as in Example 1, except that the immersion time was 60 minutes.

Comparative Example 1

A solar cell was manufactured in the same manner as in Example 1, except that the immersion time was 5 minutes.

Evaluation Example 1: Surface composition of CIGSe substrate

Surface compositions of the substrates on which the buffer layers formed according to Preparation Examples 1 to 2 and Comparative Preparation Example 1 were formed, were analyzed by Auger electron spectroscopy (AES).

FIG. 2 illustrates an AES spectrum.

FIG. 2A shows analysis results of the substrate having buffer layer thereon prepared according to Comparative Preparation Example 1, FIG. 2B shows analysis results of the substrate having buffer layer thereon prepared according to Preparation Example 1, and FIG. 2C shows analysis results of the substrate having buffer layer thereon prepared according to Preparation Example 2. Regarding the buffer layer formed on the light absorption layer, an upper half of the buffer layer was regarded as a first buffer layer (4b) and a lower half of the buffer layer was regarded as a second buffer layer (4a).

Referring to FIG. 2B and 2C, the first buffer layer (4b) has a higher sulfur (S) content than the second buffer layer (4a), and thus, the sulfur content continuously decreases in the direction from the first buffer layer to the second buffer layer.

Referring to FIG. 2A, the sulfur content of the first buffer layer was similar to the sulfur content of the second buffer layer.

Accordingly, it was confirmed that the first buffer layer adjacent to the window layer has greater ZnS content than the second buffer layer adjacent to the light absorption layer in the present invention.

Evaluation Example 2: Surface composition of CIGSSe substrate

In the same manner as in Evaluation Example 1, surface compositions of the substrate including the buffer layers thereon formed during a process of preparing the solar cell according to Examples 1 to 5, Reference Example 1 and Comparative Example 1 were formed, were analyzed by Auger electron spectroscopy (AES).

Regarding the buffer layer formed on the light absorption layer, an upper half of the buffer layer was regarded as a first buffer layer (4b) and a lower half of the buffer layer was regarded as a second buffer layer (4a).

From surface composition analysis results, a ZnS content, Zn(S,O,OH)content and a ratio of ZnS to Zn(S,O,OH) included in the first buffer layer and the second buffer layer were calculated.

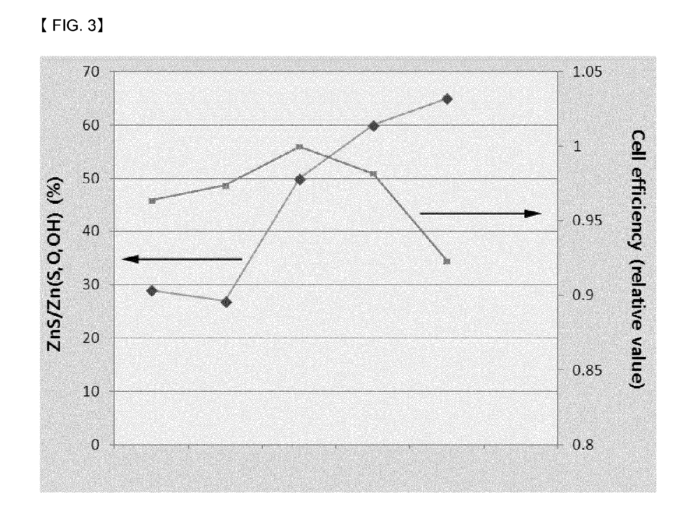

Some calculation results are shown in Table 1 and FIG. 3.

[Table 1]

|  | First buffer layer ZnS/Zn(S,O,OH) | Second buffer layer ZnS/Zn(S,O,OH) |
|---|---|---|
|  | [%] | [%] |
| Example1 | 60 | 25 |
| Example 2 | 50 | 24 |
| Example 3 | 47 | 22 |
| Example 4 | 27 | 20 |
| Example 5 | 29 | 21 |
| Reference Example 1 | 65 | 27 |
| Comparativ e Example 1 | 18 | 19 |

As shown in Table 1, regarding Examples 1 to 5, the ZnS/Zn(S,O,OH) content of the first buffer layer was higher than the ZnS/Zn(S,O,OH) content of the second buffer layer. However, regarding Comparative Example 1, the ZnS/Zn(S,O,OH) content of the first buffer layer was lower than the ZnS/Zn(S,O,OH) content of the second buffer layer.

Evaluation Example 2: Photoelectric conversion efficiency evaluation

The Current-voltage characteristics of the thin film solar cells manufactured according to Examples 1 to 5, Reference Example 1 and Comparative Example 1 were evaluated under a condition in which light with 1 sun was irradiated through a filter with air mass (AM) 1.5 and under a dark condition in which light was not irradiated. Herein, "1 sun" refers to an intensity of light source equivalent to one sun, and "AM 1.5" refers to a filter that adjusts a wavelength with solar light.

Optical current voltages of the thin film solar cells manufactured according to Examples 1 to 5, Reference Example 1, and Comparative Example 1 were measured, and then, from a graph of the measured optical current voltages, open voltage, current density, and fill factors were measured, and from the obtained results, efficiency of a solar cell was evaluated. Results thereof are shown in Table 2.

Herein, a Xenon lamp was used as a light source, and a solar condition of the Xenon lamp was corrected by using a reference solar cell (Frunhofer Institute Solare Energiesysteme, Certificate No. C-ISE369, Type of material: Mono-Si+KG filter), and the evaluation was performed at a power density of 100 mW/cm$^2$.

Measurement conditions of open voltage, optical current density, energy conversion efficiency, and fill factor are as follows:

(1) Open voltage(V) and optical current density(mA/cm$^2$): open voltage and optical current density were measured by using Keithley SMU2400; and

(2) Energy conversion efficiency(%) and fill factor (%): energy conversion efficiency was measured by using a solar simulator with 1.5AM 100 mW/cm$^2$ (equipped with Xe lamp [300W, Oriel], AM1.5 filter, and Keithley SMU2400), and the fill factor was calculated from conversion efficiency based on the following equation:

## [Equation]

$$\text{Fill factor (\%)} = \frac{(J \times V)_{max}}{J_{sc} \times V_{oc}} \times 100$$

wherein J is a value on Y axis of conversion efficiency curve, V is a value on X axis of conversion efficiency, and Jsc and Voc are respectively intercept values of the axes. The conversion efficiency ($\eta$) below corresponds to $(JxV)_{max}$.

Some calculation results are shown in Table 2 and FIG. 3.

[Table 2]

| | Current density ($J_{sc}$) [mA/cm$^2$] | Open voltage ($V_{oc}$) [V] | Fill factor(FF) [%] | Conversion efficiency($\eta$) [%] (values in parentheses are relative values) |
|---|---|---|---|---|
| Example 1 | 31.4 | 0.664 | 71.10 | 14.84 (0.98) |
| Example 2 | 31.5 | 0.670 | 71.7 | 15.14 (1.00) |
| Example 3 | 31.7 | 0.657 | 69.90 | 14.57 (0.96) |
| Example 4 | 31.8 | 0.668 | 69.10 | 14.68 (0.97) |
| Example 5 | 31.6 | 0.670 | 68.77 | 14.56 (0.96) |
| Reference Example 1 | 34 | 0.680 | 48.4 | 11.23 (0.74) |
| Comparative Example 1 | 31.9 | 0.653 | 69.30 | 14.45 (0.95) |

As shown in Table 2 and FIG. 3, the solar cells of Examples 1 to 5 have improved open voltage and conversion efficiency than the solar cell of Comparative Example 1.

## Claims

1. A solar cell comprising:

a light-absorption layer comprising a p-type compound semiconductor and a buffer layer that is disposed on the light absorption layer and contains ZnS;
wherein the buffer layer includes a second buffer layer disposed on the light absorption layer and a first buffer layer disposed on the second buffer layer, and a ZnS content of the first buffer layer is greater than in the second buffer layer.

2. The solar cell of claim 1, where the ZnS content of the buffer layer of the solar cell has a continuous concentration gradient and the ZnS content decreases in a direction from the first buffer layer to the second buffer layer.

3. The solar cell of claim 1 or claim 2, where the ZnS content of the first buffer layer ZnS/Zn(S,O,OH) is about 0.25 to about 0.63 and a ZnS content of the second buffer layer ZnS/Zn(S,O,OH) is less than about 0.25, optionally the ZnS/Zn(S,O,OH) of the first buffer layer is from about 0.25 to about 0.61, optionally from about 0.27 to about 0.60, and optionally from about 0.29 to about 0.50.

4. The solar cell of any of claims 1 to 3, where ZnS/Zn(S,O,OH) of the second buffer layer is from about 0.10 to about 0.24, optionally from about 0.15 to about 0.23, and optionally from about 0.19 to about 0.23.

5. The solar cell of any of claims 1 to 4, wherein the total buffer layer is between 1 nm to about 200 nm in thickness, optionally 1.5 nm to about 10 nm and optionally 1.7 nm to about 8 nm.

6. The solar cell of any of claims 1 to 5, wherein a thickness ratio of the first buffer layer to the second buffer layer in the solar cell is in a range of 3:1 to 1:3, optionally, a thickness ratio of the first buffer layer to the second buffer layer in the solar cell is in a range of 1.1:0.9 to 0.9:1.1.

7. The solar cell of any of claims 1 to 6, wherein the light-absorption layer region is a composition represented by Composition Formula 1 below:

$$< \text{Composition Formula 1} > \qquad Cu(In_{1-x}Ga_x)(Se_{1-y}S_y)_2$$

in Formula 1,
wherein $0 \leq x < 1$, $0 < y < 1$.

8. The solar cell of any of claims 1 to 7, wherein a surface of the light-absorption layer of the solar cell has a sulfur concentration of more than 0.5 at%.

9. The solar cell of any of claims 1 to 8, wherein the solar cell also contains a third buffer layer disposed on the first buffer layer, optionally formed of an intrinsic ZnO.

10. The solar cell of any of claims 1 to 9, wherein the solar cell is produced by a process comprising the steps of: preparing an aqueous solution including zinc sulfate ($ZnSO_4$), thiourea ($SC(NH_2)_2$) and ammonium hydroxide ($NH_4OH$); and immersing a light absorption layer including a p-type compound semiconductor in the aqueous solution for about 7 minutes to about 30 minutes.

11. The solar cell of claim 10, wherein the temperature of the aqueous solution is in a range of about 55°C to about 70°C.

12. The solar cell of claims 10 or 11, wherein the pH of the aqueous solution is in a range of about 10 to about 13.

13. The solar cell of any of claims 10 to 12, wherein the concentration of zinc sulfate is in a range of about 0.01 M to about 0.1M, optionally, wherein the thiourea concentration is in a range of about 0.2M to about 1.3M and, optionally, wherein the ammonium hydroxide concentration is in a range of about 1 M to about 5M.

14. The solar cell of any of claims 10 to 13, after the forming of the buffer layer, the process includes annealing at a temperature of about 100 to about 300°C in an atmospheric condition.

15. A process for preparing a solar cell as defined in any of claims 10 to 14.

【 FIG. 1 】

【 FIG. 2 】

【FIG. 3】